# EUROPÄISCHE PATENTSCHRIFT

(11) **EP 3 979 313 B1**
(45) Veröffentlichungstag und Bekanntmachung des Hinweises auf die Patenterteilung: **30.11.2022**
(21) Anmeldenummer: 20199403.5
(22) Anmeldetag: 30.09.2020
(51) Int. Cl.: H01L 23/373, H01L 23/40

(54) **LEISTUNGSELEKTRONISCHE EINRICHTUNG UND LEISTUNGSHALBLEITERMODUL DAMIT**
POWER ELECTRONICS DEVICE AND POWER SEMICONDUCTOR MODULE USING THE SAME
DISPOSITIF ÉLECTRONIQUE DE PUISSANCE ET MODULE SEMI-CONDUCTEUR DE PUISSANCE CORRESPONDANT

(43) Veröffentlichungstag der Anmeldung: 06.04.2022
(73) Patentinhaber: SEMIKRON Elektronik GmbH & Co. KG, 90431 Nürnberg (DE)
(72) Erfinder: Cardi, Valeriano, 00165 Rom (IT); Hopfe, Stefan, 90571 Schwaig (DE); Muscolino, Maurilio Giovannantonio, 00042 Anzio (IT); Santoro, Matteo, 00071 Pomezia (IT); Obermaier, Werner, 22455 Hamburg (DE)

(56) Entgegenhaltungen:
- EP-A1- 3 340 291
- EP-A2- 1 217 659
- DE-A1-102015 213 495
- JP-A- 2000 200 865
- US-A1- 2016 020 161

## Beschreibung

Die Erfindung beschreibt eine leistungselektronische Einrichtung mit einem Substrat mit einem flächigen Isolationsformkörper, der auf seiner ersten Hauptseite eine metallische Schicht und auf seiner zweiten Hauptseite eine Mehrzahl von Leiterbahnen aufweist, und mit einer ersten oder zweiten, vorzugsweise als zylinderförmige Ausnehmung ausgebildeten, Befestigungseinrichtung, wobei entweder das Substrat auf einer Grundplatte der leistungselektronischen Einrichtung angeordnet ist und die erste Befestigungseinrichtung dazu ausgebildet ist die Grundplatte kraftschlüssig auf einer Kühleinrichtung anzuordnen oder wobei ein Gehäuseabschnitt eine zweite Befestigungseinrichtung aufweist, die dazu ausgebildet ist das Substrat auf einer Kühleinrichtung anzuordnen. Die Erfindung beschreibt weiterhin ein Leistungshalbleitermodul mit einer derartigen leistungselektronischen Einrichtung.

Es besteht bei Leistungshalbleitermodulen grundsätzlich das Bedürfnis diese robust auszugestalten, insbesondere stellt die Befestigung auf Kühleinrichtungen immer eine Herausforderung dar hierbei nicht Kraft auf die leistungselektrische Einrichtung eines derartigen Leistungshalbleitermoduls auszuüben, die zu einer mechanischen Beeinträchtigung führen kann.

Die DE 100 63 714 A1 offenbart ein Leistungshalbleitermodul, bestehend aus einem beidseitig metallkaschierten keramischen Substrat, mit mindestens einem Halbleiterbauelement, zur Kontaktierung benötigten Anschlüssen sowie einem Gehäuse, wobei das keramische Substrat neben der Basisisolierung auch eine Funktionsisolierung bereitstellt. Das keramische Substrat weist eine metallische Kaschierung auf, das die erste bzw. zweite Oberfläche der Keramik nur teilweise bedeckt, wobei der Abstand des Metallrandes der ersten metallischen Kaschierung zum Rand der Keramik kleiner ist als der Abstand des Metallisierungsrandes der zweiten metallischen Kaschierung zum Rand der Keramik und dies als Erhöhung der Isolationsfestigkeit der Basisisolierung des Substrates wirkt.

DE 10 2015 213 495 A1 beschreibt eine Halbleitervorrichtung umfassend ein Isolationssubstrat, ein Halbleiterelement, das auf einer ersten Oberfläche des Isolationssubstrats angeordnet ist, ein Gehäuse, das mit dem Isolationssubstrat verbunden ist, und ein Harz, das in das Gehäuse gefüllt ist.

Der Erfindung liegt die Aufgabe zugrunde eine leistungselektronische Einrichtung und ein Leistungshalbleitermodul hiermit derart auszubilden, dass durch die Befestigung auf einer Kühleinrichtung die Krafteinwirkung auf die leistungselektronische Einrichtung verringert wird.

Diese Aufgabe wird erfindungsgemäß gelöst durch eine leistungselektronische Einrichtung mit einem eine Normalenrichtung aufweisenden Substrat mit einem flächigen Isolationsformkörper, der auf seiner ersten Hauptseite eine metallische Schicht und auf seiner zweiten Hauptseite eine Mehrzahl von Leiterbahnen aufweist, und mit einer ersten oder zweiten, vorzugsweise als zylinderförmige Ausnehmung ausgebildeten, Befestigungseinrichtung, wobei entweder das Substrat kraft- oder stoffschlüssig auf einer Grundplatte der leistungselektronischen Einrichtung angeordnet ist und die erste Befestigungseinrichtung dazu ausgebildet und vorgesehen ist die Grundplatte kraftschlüssig auf einer Kühleinrichtung anzuordnen oder wobei alternativ ein Gehäuseabschnitt eine zweite Befestigungseinrichtung aufweist, die dazu ausgebildet und vorgesehen ist das Substrat kraftschlüssig auf einer Kühleinrichtung anzuordnen und wobei ein Rand der metallischen Schicht gegenüber einem Rand des Isolationsformkörpers zurückversetzt ist und wobei im Bereich benachbart der ersten oder zweiten Befestigungseinrichtung ein erster Randabschnitt des Rands der metallischen Schicht weiter zurückversetzt ist als jeweils angrenzende zweite und dritte Randabschnitte des Randes der metallischen Schicht. Es kann vorteilhaft sein, wenn die Leiterbahnen ausgebildet sind aus einer weiteren in sich strukturierten metallischen Schicht, die vorzugsweise identisch ausgebildet ist wie die metallische Sicht auf der ersten Hauptseite, oder sich von dieser nur durch eine unterschiedliche Dicke unterscheidet.

Es kann besonders vorteilhaft sein, wenn der erste Randabschnitt eine Länge von mindestens dem fünffachen, bevorzugt von mindestens dem zehnfachen und vorzugsweise von maximal dem fünfzigfachen der Dicke der metallischen Schicht aufweist.

Vorzugsweise ist die stoffschlüssige Verbindung hierbei ausgebildet als eine Lot- oder Sinterverbindung. Es ist dann besonders vorteilhaft, wenn der erste Randabschnitt einen minimalen senkrechten Abstand von der ersten Befestigungseinrichtung, genauer von einer durch diese hindurchreichenden, zentralen Mittelachse von mindestens dem zehnfachen, bevorzugt von mindestens dem fünfundzwanzigfachen und vorzugsweise von maximal dem dreihundertfachen der Dicke der stoffschlüssigen Verbindung aufweist.

Vorteilhafterweise weist der erste Randabschnitt einen konkaven, geraden oder konvexen Verlauf auf. Insbesondere ist es vorteilhaft, wenn der erste Randabschnitt bei konkavem Verlauf ein Kreissegment beschreibt, mit, in Normalenrichtung betrachtet, einem Mittelpunkt des Kreissegments innerhalb der Deckfläche, vorzugsweise mittig in der Deckfläche der als zylinderförmige Ausnehmung ausgebildeten ersten oder zweiten Befestigungseinrichtung. Alternativ kann es vorteilhaft sein, wenn der erste Randabschnitt bei konkavem Verlauf ein Kreissegment beschreibt, mit, in Normalenrichtung betrachtet, einem Mittelpunkt des Kreissegments im Bereich zwischen der ersten Befestigungseinrichtung und dem benachbarten Rand der Grundplatte. Ebenso alternativ kann es vorteilhaft sein, wenn der erste Randabschnitt bei konkavem Verlauf ein Kreissegment beschreibt, mit, in Normalenrichtung betrachtet, einem Mittelpunkt des Kreissegments im Bereich zwischen der zweiten Befestigungseinrichtung und dem benachbarten Rand des Gehäuseabschnitts.

Die Aufgabe wird weiterhin gelöst durch ein Leistungshalbleitermodul mit einer vorgenannten leistungselektronischen Einrichtung mit einem Leistungshalbleiterbauelement, angeordnet auf einer der Leiterbahnen des Substrats, mit einer internen Verbindungseinrichtung und mit Anschlusselementen zur externen elektrischen Verbindung des Substrats. Vorzugsweise sind die Anschlusselemente hierbei als Last- und Hilfsanschlusselemente ausgebildet und ragen vorzugsweise durch ein Gehäuse nach außen.

Es kann vorteilhaft sein, wenn das Substrat kraft- oder stoffschlüssig auf einer Grundplatte der leistungselektronischen Einrichtung angeordnet ist und die erste Befestigungseinrichtung als zylinderförmige Ausnehmung ausgebildet ist. Hierbei kann vorzugsweise ein Gehäuse eine weitere zylinderförmige Ausnehmung aufweisen, die mit der als zylinderförmige Ausnehmung ausgebildeten Befestigungseinrichtung fluchtet.

Durch diese Ausgestaltung wird die mechanische Belastung des Substrats wirksam gemindert.

Selbstverständlich können, sofern dies nicht per se oder explizit ausgeschlossen ist, die im Singular genannten Merkmale, insbesondere die Befestigungseinrichtung oder das Leistungshalbleiterbauelement, auch mehrfach in der erfindungsgemäßen leistungselektronischen Einrichtung oder dem erfindungsgemäßen Leistungshalbleitermodul vorhanden sein.

Es versteht sich, dass die verschiedenen Ausgestaltungen der Erfindung, gleichgültig ob sie im Rahmen der Beschreibung der leistungselektronischen Einrichtung oder des Leistungshalbleitermoduls offenbart sind, einzeln oder in beliebigen Kombinationen realisiert sein können, um Verbesserungen zu erreichen. Insbesondere sind die vorstehend und im Folgenden genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterungen der Erfindung, vorteilhafte Einzelheiten und Merkmale, ergeben sich aus der nachfolgenden Beschreibung der in den Figuren 1 bis 10 schematisch dargestellten Ausführungsbeispiele der Erfindung, oder von jeweiligen Teilen hiervon.
Figur 1 zeigt eine seitliche Ansicht einer ersten grundsätzlichen Ausgestaltung eines erfindungsgemäßen Leistungshalbleitermoduls.
Figur 2 zeigt eine seitliche Ansicht einer zweiten grundsätzlichen Ausgestaltung eines erfindungsgemäßen Leistungshalbleitermoduls.
Figur 3 zeigt eine Ebene einer ersten Ausgestaltung einer erfindungsgemäßen leistungselektronischen Einrichtung.
Figur 4 zeigt eine Ebene einer zweiten Ausgestaltung einer erfindungsgemäßen leistungselektronischen Einrichtung.
Figur 5 zeigt eine dritte Ausgestaltung einer erfindungsgemäßen leistungselektronischen Einrichtung.
Figuren 6 bis 10 zeigen Varianten der Ausgestaltung des ersten Randabschnitts einer erfindungsgemäßen leistungselektronischen Einrichtung.

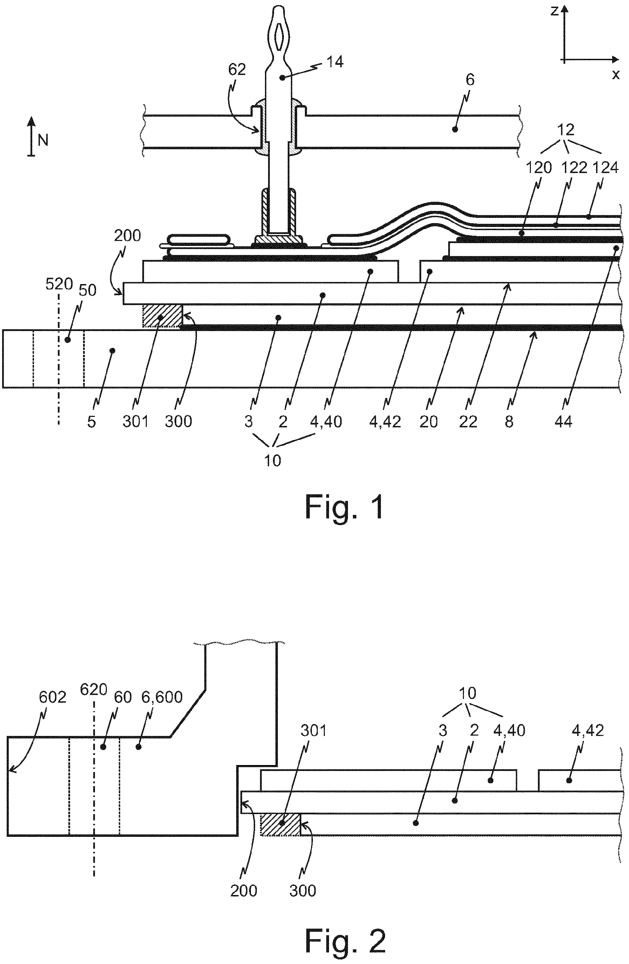

Figur 1 zeigt eine seitliche Ansicht einer ersten grundsätzlichen Ausgestaltung eines erfindungsgemäßen Leistungshalbleitermoduls. Dieses weist ein Substrat 10, mit einem Isolationsformkörper 2 und auf seiner zweiten Hauptseite 22 angeordnet eine erste und eine zweiten Leiterbahn 40,42 auf. Auf der zweiten Leiterbahn 42 des Substrats 10 ist ein Leistungshalbleiterbauelement 44 angeordnet und mit seiner der zweiten Leiterbahn 42 zugewandten Kontaktfläche elektrisch leitend mit dieser verbunden. Diese elektrisch leitende Verbindung ist hier, ohne Beschränkung der Allgemeinheit, als eine stoffschlüssige Drucksinterverbindung ausgebildet.

Das Leistungshalbleiterbauelement 44, genauer dessen dem Substrat 10 in Normalenrichtung N abgewandte Kontaktfläche, ist mit einer ersten Leiterbahn 40 mittels einer internen Verbindungseinrichtung 12 verbunden. Diese Verbindungseinrichtung 12 ist ausgebildet als ein Folienverbund aus einer, dem Substrat 10 zugewandten, ersten elektrisch leitfähigen Folie 120, einer im Folienverbund folgenden elektrisch isolierenden Folie 122 und einer im Folienverbund weiter folgenden zweiten elektrisch leitfähigen Folie 124.

Die leistungselektronische Einrichtung 1 weist weiterhin ein Anschlusselement 14, hier genauer ein Hilfsanschlusselement, zur Führung von Hilfspotentialen, wie beispielhaft Sensor- oder Ansteuersignalen, auf. Dieses Anschlusselement 14 ist ausgebildet als ein fachübliches Pressfit-Kontaktelement. Der Fuß dieses Pressfit-Kontaktelements ist in einer Hülse elektrisch leitend angeordnet, wobei die Hülse stoffschlüssig mit einem Kontaktabschnitt auf der dem Substrat 10 abgewandten Oberfläche der ersten elektrisch leitfähigen Folie 120 verbunden ist. Das Pressfit-Kontaktelement reicht durch eine Ausnehmung 62 eines nur abschnittsweise dargestellten Gehäuses 6 des Leistungshalbleitermoduls durch dieses hindurch.

Diese erste elektrisch leitfähige Folie 120 ist mit der ersten Leiterbahn 40 des Substrats 10 mittels einer stoffschlüssigen und elektrisch leitfähigen Verbindung, hier ausgebildet als fachübliche Drucksinterverbindung, verbunden.

Das Substrat 10 weist weiterhin eine metallische Schicht 3 auf, die auf der ersten Hauptseite 20 des Isolationsformkörpers 2 angeordnet ist. Die Leiterbahnen 40,42 auf der zweiten Hauptseite 22 sind aus einer weiteren metallischen Schicht durch Strukturierung dieser ausgebildet. Der Isolationsformkörper 2 weist hier eine Dicke von 300µm auf, während die metallischen Schichten jeweils eine Dicke von 350µm aufweist. Dies sind typische Werte für derartige Substrate 10 und gelten auch für die weiteren Ausführungsbeispiele.

Die metallische Schicht 3 ist mittels einer stoffschlüssigen Verbindung 8 mit einer Grundplatte 5 der leistungselektronischen Einrichtung 1 und damit des Leistungshalbleitermoduls verbunden. Diese Verbindung 8 weist eine Dicke von ca. 150µm auf und ist hier als Lotverbindung ausgebildet. Eine ebenfalls technisch sinnvolle Alternative hierzu ist eine Sinter-, insbesondere eine Drucksinter-, Verbindung.

Die Grundplatte 5 weist im Rand- oder, hier genauer, im Eckbereich eine erste Befestigungseinrichtung 50 auf, die hier als durchgehende zylinderförmige Ausnehmung ausgestaltet ist. Dargestellt ist hier zudem die Mittelachse 520 dieser Ausnehmung. Diese Ausnehmung ist dafür vorgesehen, dass damit das Leistungshalbleitermodul auf einer Kühleinrichtung, typischerweise kraftschlüssig, befestigt wird.

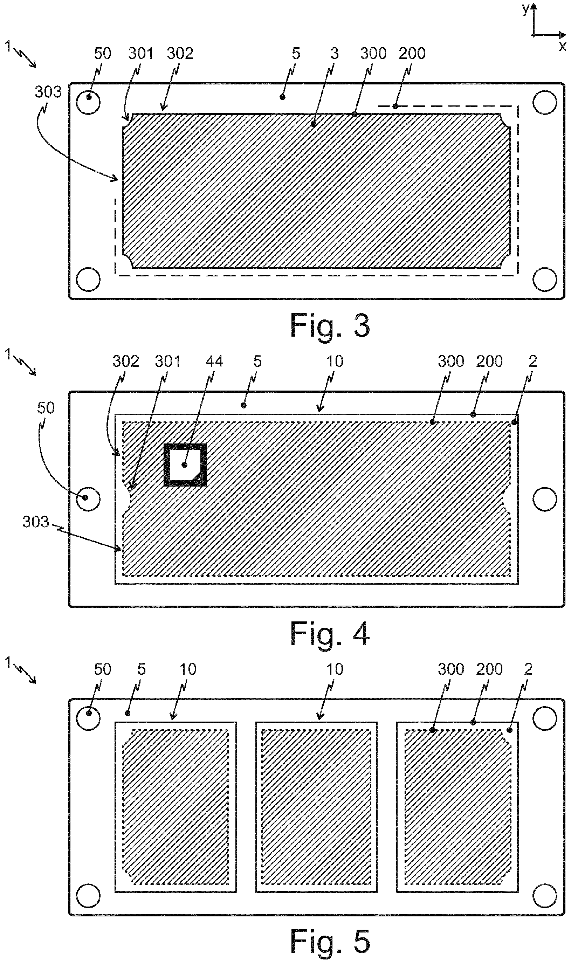

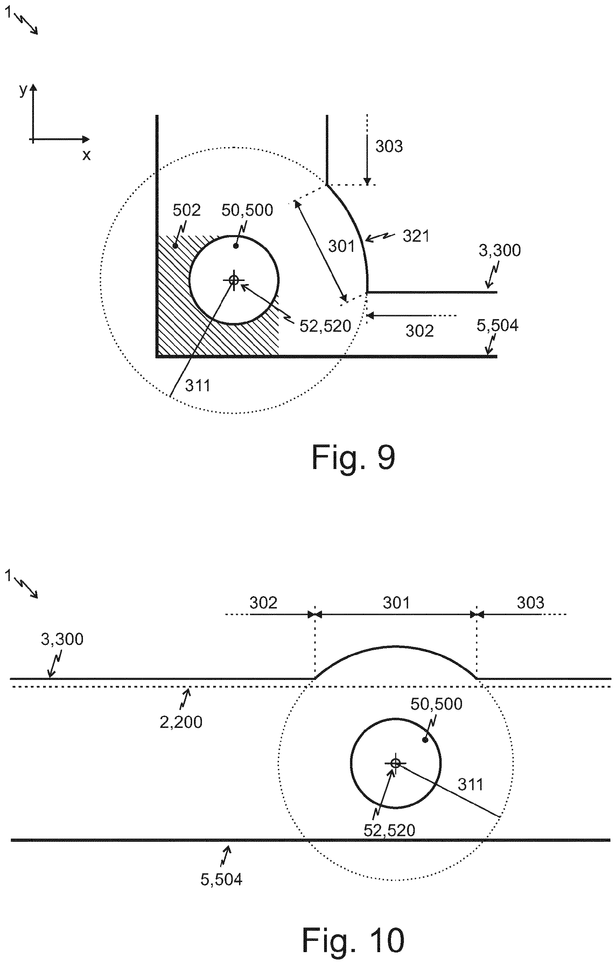

Grundsätzlich und fachüblich ist der Rand 300 der metallischen Schicht 3 gegenüber dem Rand 200 des Isolationsformkörpers 2 zurückversetzt, wodurch ein umlaufender Randabschnitt der ersten Hauptseite 20 des Isolationsformkörpers 2 nicht von der metallischen Schicht 3 bedeckt ist. Benachbart zur ersten Befestigungseinrichtung 50 ist der Rand der metallischen Schicht 300 in einem ersten Randabschnitt 301 weiter zurückversetzt als in den jeweils daran anschließenden zweiten und dritten Randabschnitten 302,303, vgl. Figuren 3 bis 10. Es ergibt sich somit ein zusätzlicher nicht von der metallischen Schicht 3 bedeckter Abschnitt der ersten Hauptseite 20 des Isolationsformkörpers 2. Weitere Merkmale dieser Randabschnitte, insbesondere zu deren Dimensionierung, werden insbesondere bei Figur 9 beschrieben.

Figur 2 zeigt eine seitliche Ansicht einer zweiten grundsätzlichen Ausgestaltung eines erfindungsgemäßen Leistungshalbleitermoduls. Diese weist im Unterschied zur ersten Ausgestaltung keine Grundplatte auf. Vielmehr ist hier das Substrat 10 dafür vorgesehen direkt auf einer Kühleinrichtung angeordnet zu werden. Typisch, aber nicht zwingend notwendig, ist bei derartigen Ausgestaltungen, dass das Substrat 10 kraftschlüssig auf der Kühleinrichtung angeordnet ist.

Hier dargestellt ist nur das Substrat 10 ohne Leistungshalbleiterbauelemente und ohne interne Verbindungseinrichtung. Umlaufend um das Substrat 10 und fachüblich meist auch das Substrat überdeckend ist ein Gehäuse 6 angeordnet. Dieses Gehäuse weist im Rand- oder Eckbereich eine zweite Befestigungseinrichtung 60 auf, die wiederum als durchgehende zylinderförmige Ausnehmung ausgestaltet ist. Dargestellt ist hier zudem die Mittelachse 620 dieser Ausnehmung. Diese Ausnehmung ist dafür vorgesehen, dass damit das Leistungshalbleitermodul auf der Kühleinrichtung befestigt wird. Das Substrat 10 ist hier vollständig identisch ausgebildet wie bei der ersten Ausgestaltung gemäß Figur 1.

Figur 3 zeigt eine Ebene einer ersten Ausgestaltung einer erfindungsgemäßen leistungselektronischen Einrichtung 1. Dargestellt ist in Draufsicht aus Normalenrichtung N ein Schnitt durch die metallische Schicht 3. Unter dieser metallischen Schicht 3 ist die Grundplatte 5 angeordnet und weist jeweils im Eckbereich einen erste Befestigungseinrichtung 50 mit einem Durchmesser von 8mm auf, die im Übrigen wie unter Figur 1 beschrieben ausgebildet ist.

Die metallische Schicht 3 weist einen Rand 300 auf, der gegenüber dem Rand 200 des Isolationsformkörpers 2, der teilweise gestrichelt dargestellt ist, zurückversetzt ist. Benachbart zu allen ersten Befestigungseinrichtungen 50 ist jeweils ein erster Randabschnitt 301 ausgebildet, der gegenüber dem Rand 200 des Isolationsformkörpers 2 weiter zurückversetzt ist. An diesen ersten Abschnitt 301 schließt sich an der Längsseite der leistungselektronischen Einrichtung 1 ein zweiter, fachüblich ausgestalteter Randabschnitt 302 und an der Schmalseite ein dritter, ebenfalls fachüblich ausgestalteter, Randabschnitt 303 an. Diese sind somit nicht so weit zurückversetzt wie der erste Randabschnitt 301.

Figur 4 zeigt eine Ebene einer zweiten Ausgestaltung einer erfindungsgemäßen leistungselektronischen Einrichtung 1. Dargestellt ist eine Draufsicht aus Normalenrichtung N auf das Substrat 10, wobei Leiterbahnen nicht dargestellt sind und das eine dargestellte Leistungshalbleiterbauelement 44 nur erläuternd ist. Unter dem Isolationsformkörper 2 ist die metallische Schicht 3 punktiert dargestellt. Darunter ist wiederum die Grundplatte 5 angeordnet, die hier an den Schmalseiten mittig jeweils eine erste Befestigungseinrichtung 50 aufweist.

Die metallische Schicht 3 weist wiederum einen Rand 300 auf, der gegenüber dem Rand 200 des Isolationsformkörpers 2 zurückversetzt ist. Benachbart zu allen ersten Befestigungseinrichtungen 50 ist jeweils ein erster Randabschnitt 301 ausgebildet, der gegenüber dem Rand 200 des Isolationsformkörper 2 weiter zurückversetzt ist. An diesen, mittig auf der Schmalseite gelegenen, ersten Abschnitt 301 schließen sich im weiteren Verlauf der jeweiligen Schmalseite der leistungselektronischen Einrichtung 1 ein zweiter und dritter, fachüblich ausgestalteter Randabschnitt 302,303 an. Diese sind somit jeweils nicht so weit zurückversetzt wie der erste Randabschnitt 301.

Figur 5 zeigt eine dritte Ausgestaltung einer erfindungsgemäßen leistungselektronischen Einrichtung mit einer Mehrzahl von, hier beispielhaft drei, Substraten 10. Jedes Substrat 10, das direkt benachbart zu einer ersten Befestigungseinrichtung 50 angeordnet ist, weist dort einen ersten Randabschnitt 301 auf. Dieser ist jeweils wie unter Figur 3 beschrieben ausgebildet.

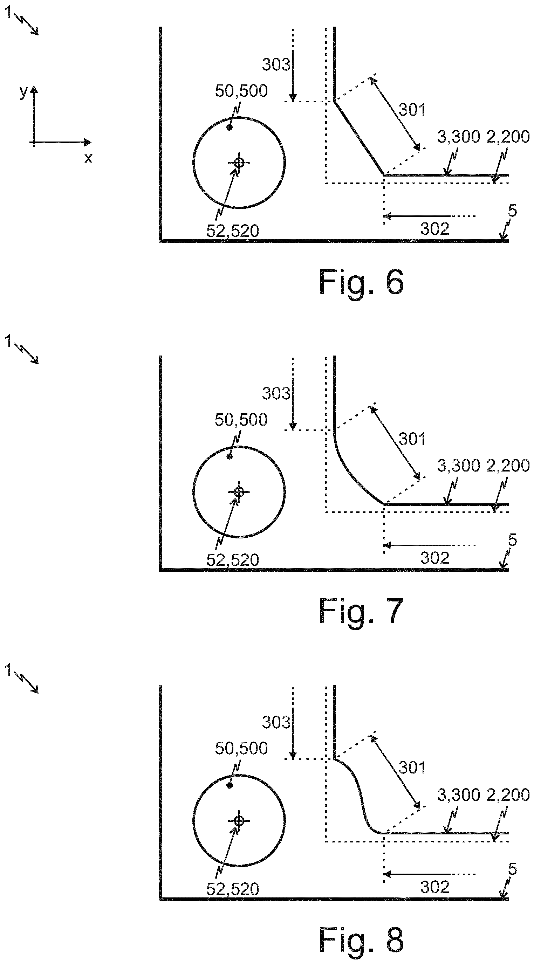

Figuren 6 bis 10 zeigen Detaildarstellungen von Varianten der Ausgestaltung einer erfindungsgemäßen leistungselektronischen Einrichtung 1, insbesondere des Bereichs, in dem der erste Randabschnitt 301 angeordnet ist. In den Figuren 6 bis 9 ist jeweils ein Eckbereich einer Grundplatte 5, vergleichbar zu Figur 3 oder 5, dargestellt. Dieser Eckbereich weist eine erste Befestigungseinrichtung 50, die als durchgehende zylinderförmige Ausnehmung ausgebildet ist, auf. Deren virtuelle Deckfläche 500 weist einen Mittelpunkt 52 auf, durch die die Mittelachse 520, vgl. Figur 1, senkrecht, in z-Richtung, hindurchreicht. Weiterhin und gestrichelt dargestellt ist der Isolationsformkörper 2 mit seinem Rand 200 und die metallische Schicht 3 auf dessen erster Hauptseite 20, vgl. Figur 1. Die jeweiligen Ausführungsformen unterscheiden sich in der Ausgestaltung des ersten Randabschnitts 301. Die jeweils daran anschließenden zweiten und dritten Randabschnitte 302,303 sind jeweils gleich ausgestaltet wie unter Figur 3 und 5 beschrieben.

Der erste Randabschnitt 301 der Ausgestaltung gemäß Figur 6 ist ausgebildet als eine Abschrägung des Eckbereichs mit einem geraden Verlauf. Der erste Randabschnitt 301 der Ausgestaltung gemäß Figur 7 ist ausgebildet mit einem konvexen Verlauf.

Hierbei ist, jeweils rein beispielhaft, der Übergang zum zweiten Randabschnitt 302 unstetig, während derjenige zum dritten Randabschnitt 303 stetig ausgebildet. Der erste Randabschnitt 301 der Ausgestaltung gemäß Figur 8 ist ausgebildet als ein Beispiel für einen kurvenartigen Verlauf mit konkaven und konvexen, möglich sind auch gerade, Elementen. Hierbei ist, jeweils rein beispielhaft, der Übergang zum zweiten Randabschnitt 302 stetig, während derjenige zum dritten Randabschnitt 303 unstetig ausgebildet.

Der erste Randabschnitt 301 der Ausgestaltung gemäß Figur 9 ist ausgebildet mit einem konkaven Verlauf, hier noch spezieller ausgebildet als Kreissegment 321. Der Mittelpunkt des Kreises bzw. des Kreissegments 321 mit einem Radius 311 liegt hier auf der Mittelachse 520, die mittig durch die erste Befestigungseinrichtung 50 hindurchreicht. Alternativ kann der Mittelpunkt des Kreissegments 321 in Projektion auf die Oberfläche der Grundplatte 5 an beliebiger Stelle innerhalb der Deckfläche 500 der als zylinderförmige Ausnehmung ausgebildeten ersten Befestigungseinrichtung 50 liegen. Weiterhin alternativ kann der Mittelpunkt 52 des Kreissegments 321 in Projektion auf die Oberfläche der Grundplatte 5 im Bereich 502 zwischen der ersten Befestigungseinrichtung 50 und dem benachbarten Rand 504 der Grundplatte 5 liegen.

In der Figur 10 ist eine Schmalseite einer Grundplatte 5, vergleichbar zu Figur 4, dargestellt. In der Mitte dieser Schmalseite ist eine erste Befestigungseinrichtung 50, die wiederum als durchgehende zylinderförmige Ausnehmung ausgebildet ist, angeordnet. Weiterhin und gestrichelt dargestellt ist der Isolationsformkörper 2 mit seinem Rand 200 und die metallische Schicht auf dessen erster Hauptseite 20, vgl. Figur 1. An diesen ersten Randabschnitt 301 schließen sich jeweils der zweite und dritte Randabschnitt 302,303 an, die jeweils gleich ausgestaltet sind wie unter Figur 4 beschrieben. Der erste Randabschnitt 301 ist wiederum ausgebildet mit einem konkaven Verlauf, hier ebenfalls wieder ausgebildet als Kreissegment 321. Bezüglich des Mittelpunkts des Kreises, bzw. des Kreissegments 321 gilt das unter Figur 9 bereits genannte analog.

## Patentansprüche

1. Leistungselektronische Einrichtung (1) mit einem eine Normalenrichtung (N) aufweisenden Substrat (10) mit einem flächigen Isolationsformkörper (2), der auf seiner ersten Hauptseite (20) eine metallische Schicht (3) und auf seiner zweiten Hauptseite (22) eine Mehrzahl von Leiterbahnen (40,42) aufweist, und mit einer ersten oder zweiten, vorzugsweise als zylinderförmige Ausnehmung ausgebildeten, Befestigungseinrichtung (50,60), wobei entweder das Substrat (10) kraft- oder stoffschlüssig auf einer Grundplatte (5) der leistungselektronischen Einrichtung angeordnet ist und die erste Befestigungseinrichtung (50) dazu ausgebildet und vorgesehen ist die Grundplatte (5) kraftschlüssig auf einer Kühleinrichtung anzuordnen oder wobei alternativ ein Gehäuseabschnitt (600) eine zweite Befestigungseinrichtung (60) aufweist, die dazu ausgebildet und vorgesehen ist das Substrat (10) kraftschlüssig auf einer Kühleinrichtung anzuordnen und wobei ein Rand (300) der metallischen Schicht gegenüber einem Rand (200) des Isolationsformkörpers (2) zurückversetzt ist und wobei im Bereich benachbart der ersten oder zweiten Befestigungseinrichtung (50,60) ein erster Randabschnitt (301) des Rands der metallischen Schicht (3) weiter zurückversetzt ist als jeweils angrenzende zweite und dritte Randabschnitte (302,303) des Randes (300) der metallischen Schicht (3).

2. Leistungselektronische Einrichtung nach Anspruch 1, wobei die Leiterbahnen (40,42) ausgebildet sind aus einer weiteren in sich strukturierten metallischen Schicht (4).

3. Leistungselektronische Einrichtung nach einem der vorhergehenden Ansprüche, wobei
der erste Randabschnitt (301) eine Länge von mindestens dem fünffachen, bevorzugt von mindestens dem zehnfachen und vorzugsweise von maximal dem fünfzigfachen der Dicke der metallischen Schicht (3) aufweist.

4. Leistungselektronische Einrichtung nach einem der vorhergehenden Ansprüche, wobei
eine stoffschlüssige Verbindung (8) ausgebildet ist als eine Lot- oder Sinterverbindung.

5. Leistungselektronische Einrichtung nach Anspruch 4, wobei
der erste Randabschnitt (301) einen minimalen Abstand von der ersten Befestigungseinrichtung (50) von mindestens dem zehnfachen, bevorzugt von mindestens dem fünfundzwanzigfachen und vorzugsweise von maximal dem dreihundertfachen der Dicke der stoffschlüssigen Verbindung (8) aufweist.

6. Leistungselektronische Einrichtung nach einem der vorhergehenden Ansprüche, wobei
der erste Randabschnitt (301) einen konkaven, geraden oder konvexen Verlauf aufweist.

7. Leistungselektronische Einrichtung nach Anspruch 6, wobei
der erste Randabschnitt (301) bei konkavem Verlauf ein Kreissegment (321) beschreibt, mit, in Normalenrichtung (N) betrachtet, einem Mittelpunkt des Kreissegments innerhalb der Deckfläche (500), vorzugsweise mittig in der Deckfläche (500) der als zylinderförmige Ausnehmung ausgebildeten ersten oder zweiten Befestigungseinrichtung (50,60).

8. Leistungselektronische Einrichtung nach Anspruch 6, wobei
der erste Randabschnitt (301) bei konkavem Verlauf ein Kreissegment (321) beschreibt, mit, in Normalenrichtung (N) betrachtet, einem Mittelpunkt (52) des Kreissegments im Bereich (502) zwischen der ersten Befestigungseinrichtung 50 und dem benachbarten Rand (504) der Grundplatte (5).

9. Leistungselektronische Einrichtung nach Anspruch 6, wobei
der erste Randabschnitt (301) bei konkavem Verlauf ein Kreissegment (321) beschreibt, mit, in Normalenrichtung (N) betrachtet, einem Mittelpunkt des Kreissegments im Bereich zwischen der zweiten Befestigungseinrichtung (60) und dem benachbarten Rand (602) des Gehäuseabschnitts (600).

10. Leistungshalbleitermodul mit einer leistungselektronischen Einrichtung nach einem der vorhergehenden Ansprüche, mit einem Leistungshalbleiterbauelement (44), angeordnet auf einer der Leiterbahnen (40,42) des Substrats (10), mit einer internen Verbindungseinrichtung (12) und mit Anschlusselementen (14) zur externen elektrischen Verbindung des Substrats (10).

11. Leistungshalbleitermodul nach Anspruch 10, wobei
die Anschlusselemente (14) als Last- und Hilfsanschlusselemente ausgebildet sind.

12. Leistungshalbleitermodul nach Anspruch 10 oder 11, wobei
die Anschlusselemente (14) durch ein Gehäuse (6) nach außen ragen.

13. Leistungshalbleitermodul nach Anspruch 10 bis 12, wobei
das Substrat (10) kraft- oder stoffschlüssig auf einer Grundplatte (5) der leistungselektronischen Einrichtung angeordnet ist und die erste Befestigungseinrichtung (50) als zylinderförmige Ausnehmung ausgebildet ist.

14. Leistungshalbleitermodul nach Anspruch 13, wobei
ein Gehäuse eine weitere zylinderförmige Ausnehmung aufweist, die mit der als zylinderförmige Ausnehmung ausgebildeten Befestigungseinrichtung (50) fluchtet.

## Claims

1. Electronic power unit (1) having a substrate (10) that has a perpendicular direction (N) and has a flat insulating moulded body (2) that has a metal layer (3) on its first main face (20) and a plurality of conductor tracks (40, 42) on its second main face (22), and having a first or second fastening device (50, 60) that is preferably embodied as a cylindrical cut-out, wherein either the substrate (10) is arranged in a non-positive locking or materially-bonded manner on a base plate (5) of the electronic power unit and the first fastening device (50) is embodied and provided so as to arrange the base plate (5) in a non-positive locking manner on a cooling device or wherein alternatively a housing section (600) has a second fastening device (60) that is embodied and provided so as to arrange the substrate (10) in a non-positive locking manner on a cooling device and wherein an edge (300) of the metal layer is offset to the rear with respect to an edge (200) of the insulating moulded body (2) and wherein in the region adjacent to the first or second fastening device (50, 60) a first edge section (301) of the edge of the metal layer (3) is offset to the rear further than in each case adjoining second and third edge sections (302, 303) of the edge (300) of the metal layer (3).

2. Electronic power unit according to Claim 1, wherein the conductor tracks (40, 42) are embodied from a further metal layer (4) that is itself structured.

3. Electronic power unit according to one of the preceding claims, wherein the first edge section (301) has a length of at least five times, preferably at least ten times and preferably a maximum fifty times the thickness of the metal layer (3).

4. Electronic power unit according to one of the preceding claims, wherein a materially bonded connection (8) is embodied as a solder or sinter connection.

5. Electronic power unit according to Claim 4, wherein the first edge section (301) has a minimum distance from the first fastening device (50) of at least ten times, preferably at least twenty five times and preferably a maximum three hundred times the thickness of the materially bonded connection (8).

6. Electronic power unit according to one of the preceding claims, wherein the first edge section (301) has a concave, straight or convex progression.

7. Electronic power unit according to Claim 6, wherein the first edge section (301) in the case of a concave progression describes a circle segment (321), having when viewed in the perpendicular direction (N) a middle point of the circle segment within the cover area (500) preferably centrally in the cover area (500) of the first or second fastening device (50, 60) that is embodied as a cylindrical cut-out.

8. Electronic power unit according to Claim 6, wherein the first edge section (301) in the case of a concave progression describes a circle segment (321), having when viewed in the perpendicular direction (N) a middle point (52) of the circle segment in the region (502) between the first fastening device (50) and the adjacent edge (504) of the base plate (5).

9. Electronic power unit according to Claim 6, wherein the first edge section (301) in the case of a concave progression describes a circle segment (321), having when viewed in the perpendicular direction (N) a middle point of the circle segment in the region between the second fastening device (60) and the adjacent edge (602) of the housing section (600).

10. Semiconductor power module having an electronic power unit according to one of the preceding claims, having a power semiconductor element (44) arranged on one of the conductor tracks (40, 42) of the substrate (10), having an internal connection device (12) and having connection elements (14) for the external connection in an electrical manner of the substrate (10).

11. Semiconductor power module according to Claim 10, wherein the connection elements (14) are embodied as load and auxiliary connection elements.

12. Semiconductor power module according to Claim 10 or 11, wherein the connection elements (14) protrude outward through a housing (6).

13. Semiconductor power module according to Claim 10 to 12, wherein the substrate (10) is arranged in a non-positive locking or materially-bonded manner on a base plate (5) of the electronic power unit and the first fastening device (50) is embodied as a cylindrical cut-out.

14. Semiconductor power module according to Claim 13, wherein a housing has a further cylindrical cut-out that is flush with the fastening device (50) that is embodied as a cylindrical cut-out.

## Revendications

1. Dispositif électronique de puissance (1) comprenant un substrat (10), qui présente une direction normale (N) et qui comporte un corps moulé isolant (2) sensiblement bidimensionnel pourvu d'une couche métallique (3) sur sa première face principale (20) et d'une pluralité de pistes conductrices (40, 42) sur sa deuxième face principale (22), et un premier ou un deuxième dispositif de fixation (50, 60), de préférence réalisé sous la forme d'un évidement cylindrique, le substrat (10) étant disposé en force ou par liaison de matière sur une plaque de base (5) du dispositif électronique de puissance, et le premier dispositif de fixation (50) étant conçu et prévu pour disposer la plaque de base (5) en force sur un dispositif de refroidissement ou, en variante, une portion de boîtier (600) comportant un deuxième dispositif de fixation (60) qui est conçu et prévu pour disposer le substrat (10) en force sur un dispositif de refroidissement et un bord (300) de la couche métallique étant en retrait par rapport à un bord (200) du corps moulé isolant (2) et, dans la zone adjacente au premier ou au deuxième dispositif de fixation (50, 60), une première portion de bord (301) du bord de la couche métallique (3) étant davantage en retrait que les deuxième et troisième portions de bord adjacentes (302, 303) du bord (300) de la couche métallique (3).

2. Dispositif électronique de puissance selon la revendication 1, les pistes conductrices (40, 42) étant formées à partir d'une autre couche métallique à structure intrinsèque (4).

3. Dispositif électronique de puissance selon l'une des revendications précédentes, la première portion de bord (301) ayant une longueur d'au moins cinq fois, de préférence d'au moins dix fois et avantageusement d'au plus cinquante fois, l'épaisseur de la couche métallique (3).

4. Dispositif électronique de puissance selon l'une des revendications précédentes, une liaison de matière (8) étant conçue comme une liaison soudée ou frittée.

5. Dispositif électronique de puissance selon la revendication 4, la première portion de bord (301) étant à une distance minimale par rapport au premier dispositif de fixation (50) d'au moins dix fois, de préférence d'au moins vingt-cinq fois et avantageusement d'au plus trois cents fois, l'épaisseur de la liaison de matière (8).

6. Dispositif électronique de puissance selon l'une des revendications précédentes, la première portion de bord (301) présentant un profil concave, droit ou convexe.

7. Dispositif électronique de puissance selon la revendication 6, la première portion de bord (301) décrivant, dans le cas d'un profil concave, un segment de cercle (321), un point central du segment de cercle étant situé, dans une vue dans la direction normale (N), à l'intérieur de la surface supérieure (500), de préférence au milieu de la surface supérieure (500) du premier ou deuxième dispositif de fixation (50, 60) conçu comme un évidement cylindrique.

8. Dispositif électronique de puissance selon la revendication 6, la première portion de bord (301) décrivant, dans le cas d'un profil concave, un segment de cercle (321), un point central (52) du segment de cercle étant situé, dans une vue dans la direction normale (N), dans la zone (502) entre le premier dispositif de fixation 50 et le bord adjacent (504) de la plaque de base (5).

9. Dispositif électronique de puissance selon la revendication 6, la première portion de bord (301) décrivant, dans le cas d'un profil concave, un segment de cercle (321), un point central du segment de cercle étant situé, dans une vue dans la direction normale (N), dans la zone entre le deuxième dispositif de fixation (60) et le bord adjacent (602) de la portion de boîtier (600).

10. Module semi-conducteur de puissance pourvu d'un dispositif électronique de puissance selon l'une des revendications précédentes, ledit module comprenant un composant semi-conducteur de puissance (44) disposé sur l'une des pistes conductrices (40, 42) du substrat (10), un dispositif de liaison intérieur (12) et des éléments formant bornes (14) destinés à la liaison électrique extérieur du substrat (10).

11. Module semi-conducteur de puissance selon la revendication 10, les éléments formant bornes (14) étant conçus comme des éléments formant bornes de charge et auxiliaires.

12. Module semi-conducteur de puissance selon la revendication 10 ou 11, les éléments formant bornes (14) faisant saillie vers l'extérieur à travers un boîtier (6).

13. Module semi-conducteur de puissance selon les revendications 10 à 12, le substrat (10) étant disposé en force ou par liaison de matière sur une plaque de base (5) du dispositif électronique de puissance et le premier dispositif de fixation (50) étant conçu comme un évidement cylindrique.

14. Module semi-conducteur de puissance selon la revendication 13, un boîtier comportant un autre évidement cylindrique qui est aligné avec le dispositif de fixation (50) réalisé sous la forme d'un évidement cylindrique.
